# Europäisches Patentamt

# European Patent Office

# Office européen des brevets

(19)

(11) Publication number: **0 053 113**
**B1**

(12) **EUROPEAN PATENT SPECIFICATION**

(45) Date of publication of patent specification: **03.09.86**

(21) Application number: **81900321.1**

(22) Date of filing: **22.12.80**

(86) International application number:
**PCT/US80/01697**

(87) International publication number:
**WO 81/01926 09.07.81 Gazette 81/16**

(51) Int. Cl.⁴: **H 03 K 17/60**, H 03 L 5/00,
H 03 K 3/01, H 03 K 3/26,
H 03 K 3/42

(54) **CONTROL CIRCUITRY USING TWO BRANCH CIRCUITS FOR HIGH-VOLTAGE SOLID-STATE SWITCHES.**

(30) Priority: **28.12.79 US 107777**

(43) Date of publication of application:
**09.06.82 Bulletin 82/23**

(45) Publication of the grant of the patent:
**03.09.86 Bulletin 86/36**

(84) Designated Contracting States:
**DE FR GB NL SE**

(56) References cited:
US-A-3 821 565
US-A-4 065 669
US-A-4 115 707
US-A-4 125 787
US-A-4 137 428
US-A-4 203 047
US-A-4 217 504
US-A-4 242 697

(73) Proprietor: **Western Electric Company,
Incorporated
222 Broadway
New York, NY 10038 (US)**

(72) Inventor: **DAVIS, James Alvin
547 Prince Edward Road
Glen Ellyn, IL 60137 (US)**
Inventor: **MACPHERSON, William Frederick
27W 184 Wallace Road
Wheaton, IL 60187 (US)**
Inventor: **MUSSMAN, Harry Edward
265 Spring Avenue
Glen Ellyn, IL 60137 (US)**
Inventor: **SHACKLE, Peter William
1395 Croyden Road
Bridgewater, NJ 08807 (US)**

(74) Representative: **Buckley, Christopher Simon
Thirsk et al
Western Electric Company Limited
5 Mornington Road
Woodford Green Essex IG8 OTU (GB)**

Courier Press, Leamington Spa, England.

## Description

This invention relates to a control circuit for controlling the state of solid-state switches and, in particular, to control circuitry for controlling the state of solid-state switches which have high voltage and relatively high current capabilities.

High voltage and relatively high current capability solid-state switches, such as one described in an article entitled "A Field Terminated Diode" by Douglas E. Houston et al., published in *IEEE Transactions on Electron Devices*, Vol. ED-23, No. 8, August 1976, and that described in "A 500V Monolithic Bidirectional 2 × 2 Cross Point Array," by P. Shackle et al., *IEEE International Solid State Circuits Conference*, Feb., 1980, p. 170—171, have an ON (conducting) state and an OFF (blocking) state. These switches are capable of blocking relatively large potential differences in the OFF state. Each of these switches has an anode and a cathode, a control terminal generally denoted as the gate, and a semiconductor body whose bulk separates the anode, cathode, and gate regions. The parameters of the various portions of the semiconductor are such that with the anode more positive than the cathode, and the potential of the gate region being insufficient to cause the potential of a vertical cross-sectional portion of the bulk of the semiconductor body between the anode and cathode to be greater in potential than the anode or cathode regions, substantial current may flow between the anode and cathode regions via the bulk. With the opposite anode to cathode polarity the switch does not conduct. Also, when the potential of the gate region is sufficiently more positive than that of the anode and cathode regions to cause a vertical cross-sectional portion of the bulk of the semiconductor body between the anode and cathode regions to be more positive in potential than the anode and cathode regions current flow between the anode and cathode regions is inhibited. The magnitude of the needed gate potential necessary to turn off these switches is a function of the geometry and doping levels of the semiconductor regions of each switch and of the anode and cathode potentials. During the turn-off process the gate potential attracts charge carriers from the anode-to-cathode current, giving rise to a gate current. This in turn induces a voltage drop which reduces the applied gate voltage and impedes the generation and spread of the depeletion region across the device. However, the gate voltage gradually reduces the anode-to-cathode current flow so that the depletion region spreads across the device to turn it off completely, whereupon the gate current ceases. Maintenance of the gate voltage maintains the device in the off state.

Control circuitry used to apply a blocking voltage to the gate terminal of each of these switches must be able to sustain a more positive voltage than is at the anode and cathode terminals and, during the turn-off process, must be able to supply current which is generally of the same magnitude as flows through the anode and cathode of each switch.

Control circuit is known (see our GB—A—2 048 599 published under the PCT by the International Bureau on 26.06.1980 under the International Publication Number WO 80/01347) which itself uses a high voltage and current switch of the type described hereinabove to control the state of a similar switch. If a control circuit should fail to break (interrupt) current flow through an ON switch connected thereto, it is necessary to electrically disconnect the control circuitry from one of the supply potential sources. The control circuitry is then reset and reconnected to the potential source. It is then activated again so as to break conduction through the ON switch.

Usually a conventional high voltage and high current capability switch is used between the high voltage source and the control circuitry. This switch can be an optically activated switch. Generally it is a relatively expensive component and only one is used for a relatively large number of control circuits. If any of the switches to be controlled fails to turn off, it is necessary to disconnect all the control circuits from the power supply. This may result in all of the switches connected to the control circuitries being switched to the ON state independent of which state is desired. This is undesirable in some switching applications. The speed of operation may be slower and power dissipation of the above-described control circuitry may be higher than is desired in some switching applications.

It would be desirable to have circuitry capable of controlling high voltage and high current solid-state switches of the type discussed hereinabove which has improved switching time and lower power dissipation than prior art circuitry, and which can maintain some switches connected thereto in the desired state even if one of the switches being controlled fails to break current (assume the OFF state).

According to this invention there is provided a control circit for a first switching device of the type comprising a semiconductor body a bulk portion of which is of a relatively high resistivity, a first region of a first conductivity type and of a relatively low resistivity, a second region of a second conductivity type opposite that of the first conductivity type, the first and second regions being connected to output terminals of the switching device, a gate region of the second conductivity type, and a control terminal coupled to the gate region, the first, second and gate regions being mutually separated by portions of the semiconductor body bulk portion, and the parameters of the device being such that, with a first voltage applied to the control terminal a potential is established within a cross-sectional portion of the bulk of the semiconductor body which is substantially different from that of the potential of the first and second regions and which prevents current flow between the first and second regions, and, with a second voltage applied to the control terminal and with appropriate voltages applied to the output terminals, a relatively low resistance current path is established between the first and second regions by dual carrier injection, the circuit comprising a second switching device of the same type as the first switching device and having a first output terminal coupled to the control terminal of the first switching device, a first branch circuit coupled to the second switching device for controlling conduction between the first and second regions thereof and adapted to couple a first potential source to a second terminal of the second switching device, a second branch circuit coupled to the second switching device and adapted to be coupled to a second potential source which is adapted to supply additional current into the second output terminal of the second switching device if that second output terminal assumes a potential level which is significantly below a preselected potential level.

The first circuit branch rapidly switches the first switch device to an ON state such that conduction can occur through the first switch device if the potentials of the anode and cathode thereof are sufficient to support conduction, or it can inhibit conduction by maintaining the first switch device in an OFF state. The second branch circuit serves to help interrupt conduction through the first switch device independent of the potentials applied to the anode and cathode terminals thereof so long as these applied potentials are within preselected limits. Thus the second branch circuit helps switch the first switch device to an OFF state. The second circuit branch can be common to a greater number of control circuitries which each have a separate first control branch and a second switch device. One advantage of this control circuit is that if one first switch device fails to assume to the OFF "state" and the switch of the second branch circuit is opened, most other first switch devices are maintained in the preselected states by the first branch circuits. In addition, the sharing of the second branch circuit reduces costs.

The invention will now be described by way of example with reference to the accompanying drawings, in which:

FIG. 1 illustrates a solid-state bidirectional switch;

FIG. 2 illustrates a solid-state structure;

FIG. 3 illustrates control circuitry embodying the invention; and

FIG. 4 illustrates other control circuitry embodying the invention.

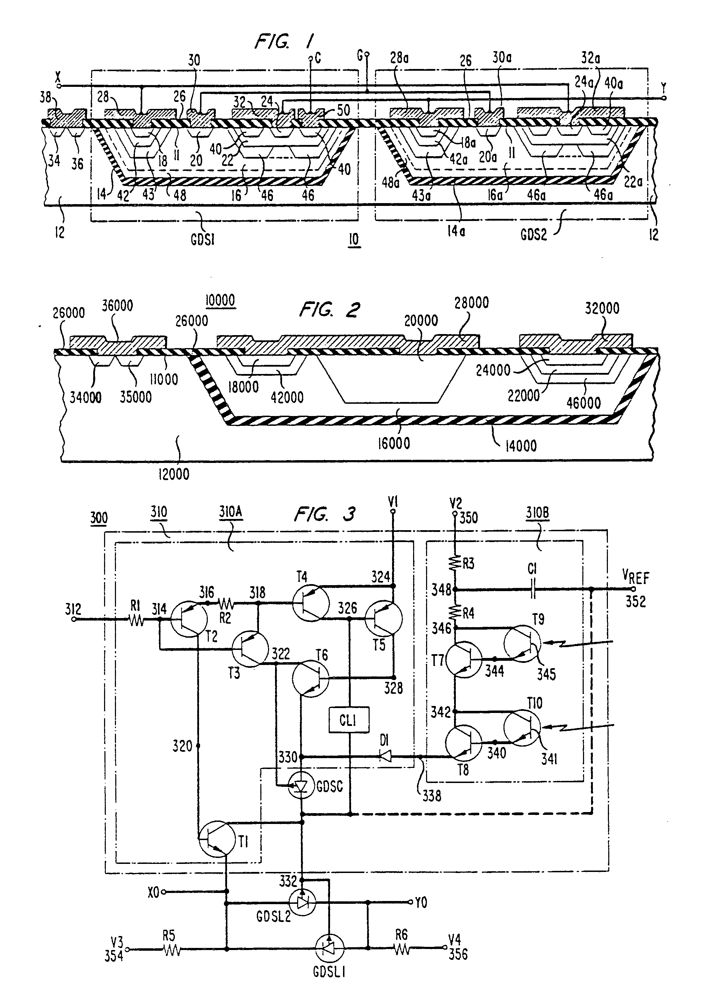

Referring now to FIG. 1, there is illustrated a semiconductor structure 10 comprising two gated diode switches, GDS1 and GDS2, which are illustrated within dashed line rectangles and are both formed on a common support member 12. Support member 12 is typically a semiconductor wafer or a substrate. Dielectric layers 14 and 14a separate monocrystalline semiconductor bodies 16 and 16a, respectively, from support member 12 and from each other. Support member 12 has a major surface 11 and bodies 16 and 16a each have a portion that is common with surface 11. Although only two gated diode switches are illustrated, a plurality of dielectrically isolated gated diode switches of the type of GDS1 and/or GDS2 can be formed in a common semiconductor wafer or substrate 12.

GDS1 and GDS2 are illustrated having electrical connections therebetween which facilitate the use thereof as a bidirectional high voltage switch. GDS1 and GDS2 need not be electrically connected and each can function independently of the other.

In one typical embodiment, support member 12 is a semiconductor wafer (substrate of n or p type conductivity and semiconductor bodies 16 and 16a have bulk portions thereof which are of p—type conductivity. The semiconductor regions contained within semiconductor body 16 are very similar to those contained in body 16a. A localized anode region 18, which is typically of p+ type conductivity, is included in body 16 and has a portion thereof that extends to surface 11. Surrounding anode regions 18 is a p type region 42 which also has a portion thereof which extends to surface 11. Surrounding region 42 is a p— type region 43 which also has a portion thereof which extends to surface 11. The conductivity of region 42 is intermediate that of anode region 18 and semiconductor body 16, and the conductivity of region 43 is intermediate that of region 42 and semiconductor body 16. Electrode 28 makes contact to region 18 and is separated from portions of surface 11 other than those over the exposed portion of region 18 by dielectric layer 26. A localized gate region 20 of n+ type conductivity is included in body 16 and has a portion thereof which extends to surface 11 and is separated from region 42 by portions of the bulk of semiconductor body 16. An electrode 30 contacts region 20 at surface 11. Electrode 30 is separated from portions of surface 11 other than those over the exposed portion of region 20 by dielectric layer 26. A localized cathode region 24, which is of n+ type conductivity, is included in body 16 and is separated from region 20 by portions of the bulk of semiconductor body 16. Region 24 is surrounded by a p+ type guard ring 40 which, in turn, is surrounded by a p type region 22 which, in turn, is surrounded by a guard ring like p type region 46. Regions 46 can extend, as is illustrated by the dashed line, to essentially completely surround region 22, except for the portions thereof common to surface 11. Region 46 is separated from regions 20 and 43 by portions of the bulk of semiconductor body 16. Electrode 32 contacts region 24 and a separate electrode 50 contacts region 40. Both electrodes are separated from portions of surface 11 other than over the respective exposed portion of regions 24 and 40. A layer 48 of n type conductivity exists between the dielectric layer 14 and semiconductor body 16. Layer 48, which is part of a preferred embodiment, is shown in dashed line since it is optional. Gate region 20 also serves as the collector of a lateral n—p—n transistor with cathode region 24 serving as the emitter and regions 46, 22, and 40 serving as the base.

Semiconductor body 16a contains regions which are very similar to those contained within semiconductor body 16 with the exception of the fact that the p+ type guard ring region 40a does not have a separate electrical contact thereto as does guard ring 40.

GDS1 is typically operated as a switch which has a low impedance between anode region 18 and cathode region 24 when in the ON (conducting) state and as a high impedance between said two regions when in the OFF (nonconducting) state. With operating potentials applied to anode region 18 and cathode region 24, the potential applied to gate region 20 determines the state of the switch. Conduction between anode region 18 and cathode region 24 can occur if the potential of the gate region 20 is near or below the potential of the anode region 18, cathode region 24, and region 22. During the ON state holes are injected into body 16 from anode region 18 and electrons are injected into body 16 from cathode region 24. This effectively lowers the resistance of body 16 such that the resistance between anode region 18 and cathode region 24 is relatively low when GDS1 is operating in the ON state. This type of operation is denoted as dual carrier injection and the type of structure described therein has been denoted as a gated diode switch (GDS). Guard ring region 40 and regions 22 and 46 help limit the punch-through of a depletion layer formed during operation between gate region 20 and cathode region 24 and help to inhibit the formation of a surface inversion layer between these two regions. In addition, they facilitate gate region 20 and cathode region 24 being relatively closely spaced apart. This facilitates relatively low resistance between anode region 18 and cathode region 22 during the ON state.

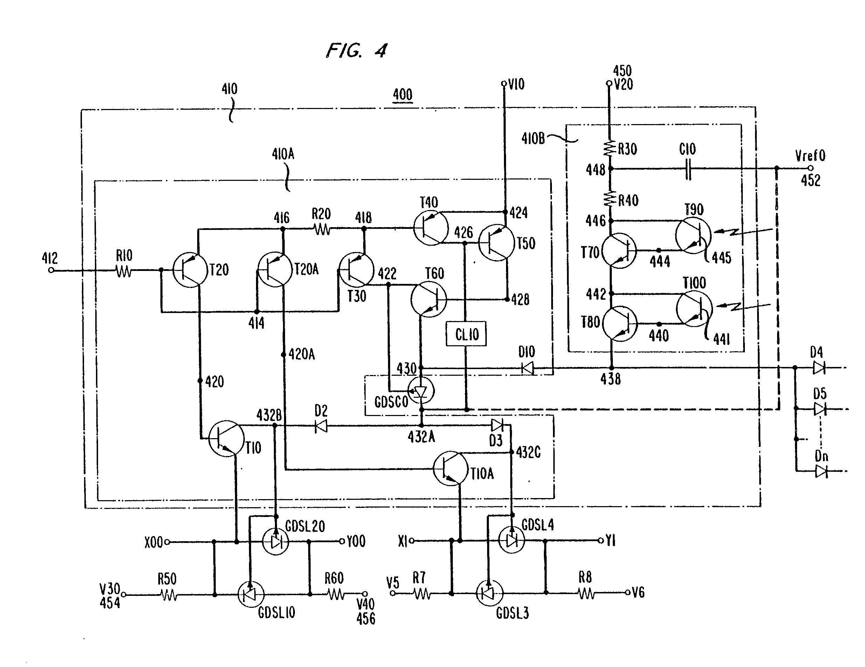

Substrate 12 is typically held at the most positive potential level available. Conduction between anode region 18 and cathode region 24 is inhibited or cut off if the potential of gate region 20 is sufficiently more positive than that of anode region 18 and cathode region 24. The amount of excess positive potential needed to inhibit or cut off conduction is a function of the geometry and impurity concentration (doping) levels of GDS1. This positive gate potential causes a portion of body 16 between gate region 20 and the portion of dielectric layer 14 therebelow to be at a potential that is more positive than that of anode region 18, cathode region 24, and region 22. This positive potential barrier inhibits the conduction of holes from anode region 18 to cathode region 24. It essentially pinches off body 16 against dielectric layer 14 in the bulk portion of semiconductor body 16 below gate region 20 and extending down to dielectric layer 14. It also serves to collect electrons emitted at cathode region 24 before they can reach anode region 18. Control circuitry for controlling gated diode switches like GDS1 and/or GDS2 is illustrated and described in FIGS. 3 and 4 herein.

The ON state can be achieved by allowing gate electrode 30 to electrically float in potential, forward-biasing the anode region 18 with respect to the cathode region 24, and applying a potential to electrode 50 which forward-biases the emitter-base junction comprising base regions 46, 22, and 40 and emitter (cathode) region 24. Once GDS1 is on, if electrode 50 is allowed to electrically float in potential, then GDS1 can be maintained in the ON state with the potential of gate region 20 at the same or a more positive level than anode region 18 and cathode region 24, so long as the potential of gate region 20 is below the level which essentially completely depletes a vertical cross-sectional portion of semiconductor body 16 between anode region 18 and cathode region 24 and from surface 11 to the top of dielectric layer 14 and causes the potential of this cross-sectional portion to be greater than that of the anode, cathode, and regions 22, 40, 46.

As has been earlier denoted, region 20, in addition to serving as the gate terminal of the gated diode switch, serves as the collector of a lateral n—p—n transistor with regions 46 and 22 serving as the base and region 24 serving as the emitter. Region 40, which also serves as part of the base, is typically of p+ type conductivity and, thus, serves as an electrical contact to region 22. Electrode 50 contacts region 40 and thus allows the base of the n—p—n transistor to be controlled. If electrode 50 is held at a positive potential with respect to electrode 32, then the n—p—n transistor is biased on and the potential between gate region 20 (the collector of the transistor) and cathode region 24 (the emitter of the transistor) is relatively small. Typically this collector-emitter voltage is on the order to several tenths to several volts. The potential of gate region 20 is thus drawn to a level close to that of the cathode region 24. This effectively reduces the gate potential to a level which is insufficient to cause the GDS to be in the OFF state with proper operating potentials applied to the anode and cathode regions. The adjusting of the potential applied to electrode 50 to forward-bias the n—p—n transistor facilitates GDS1 being relatively rapidly switched to the ON state.

Semiconductor body 16a contains essentially the same regions as semiconductor body 16, except that guard ring 40a does not have an electrical contact thereto. Thus, no external control of the base potential of the n—p—n transistor which comprises region 20a as the collector, regions 46a, 22a, and 40a as the base, and region 24a as the cathode is possible. The size of GDS1 is only slightly larger than that of GDS2. The portion of region 40 which is contacted by electrode 50 is somewhat larger than the corresponding region 40a and, accordingly, region 22 is somewhat larger than region 22a.

The electrical connections shown between electrodes 28 and 32a to a terminal X, electrodes 30 and 30a to a terminal G, and electrodes 32 and 28a to terminal Y, couple GDS1 and GDS2 together so as to form a bidirectional switching element whose equivalent circuit is illustrated in FIG. 3 herein.

Referring now to FIG. 2, there is illustrated a structure 10,000 comprising a semiconductor support member 12,000 having a major surface 11,000 and a monocrystalline semiconductor body 16,000 whose bulk is of *p* type conductivity and is separated from support member 12,000 by a dielectric layer 14,000. A p+ type conductivity contact region 34,000 and an n+ type conductivity region 35,000 exist within a portion of support member 12,000 and are both coupled to an electrode 36,000 coupled thereto. Electrode 36,000 is electrically isolated from all portions of surface 11,000, except where it contacts regions 34,000 and 35,000, by a dielectric layer 26,000.

Support member 12,000 could, and usually does, include at least one other dielectrically isolated semiconductor bodies (not illustrated) like semiconductor body 16 of FIG. 1. Localized first and second separated p+ type conductivity regions 18,000 and 24,000 are included in body 16,000 with each having a portion that forms a part of surface 11,000. A localized region 42,000 of *p* type conductivity encircles region 18,000. A localized region 22,000 of *p* type conductivity encircles region 22,000 and is itself encircled by a region 46,000 which is of p− type conductivity. Semiconductor regions of relatively low resistivity are denoted as of p+ or n+ type conductivity. Those of relatively high resistivity are denoted as of p− or n− type conductivity. Those of intermediate resistivity are denoted as *p* or *n* type conductivity. A localized n+ type conductivity region 20,000 is included in body 16,000 and is located in between regions 18,000 and 24,000. An electrode 28,000 is coupled to regions 18,000 and 20,000. A separate electrode 32,000 is coupled to region 24,000. Electrodes 28,000 and 32,000 are separated from surface 11 except where they contact the respective regions by dielectric layer 26,000.

Structure 10,000 acts essentially as a pinch resistor with region 20,000 pinching off semiconductor body 16,000 to create a relatively high resistance region between the bottom of region 20,000 and the top of dielectric layer 14,000. Structure 10,000 acts to limit current flow between regions 18,000 and 24,000. Within a first range of potential difference between regions 18,000 and 24,000, the resistance between the two regions is essentially constant and the current increases linearly with voltage. Once this range is exceeded, the electrical field created under electrode 28,000 tends to effectively further pinch off the portion of semiconductor body 16,000 under region 20,000. This increases the resistance between regions 18,000 and 24,000 and thus limits current flow from one region to the other as voltage across the regions increases. Structure 10,000 thus acts as a resistor and as a current limiter.

Referring now to FIG. 3, there is illustrated a switching system 300 comprising control circuitry 310 (within the largest dashed line rectangle) which is coupled by an output terminal 332 to the gate terminals of a pair of high voltage switching devices GDSL1 and GDSL2. The anode of GDSL1 and the cathode of GDSL2 are coupled to a first terminal Y0 and to a resistor R6 and the cathode of GDSL1 and the anode of GDSL2 are coupled to a second terminal X0 and to a resistor R5. This combination of GDSL1 and GDSL2 functions as a bidirectional switch which selectively couples terminals X0 and Y0 via a relatively low resistance path through GDSL1 and GDSL2. For illustrative purposes, these switches will be assumed to comprise the gated diode switch structure illustrated in FIG. 1. Control circuitry 310 functions so as to supply the needed potentials at terminal 332 and the current sourcing or sinking capability necessary to control the state of GDSL1 and GDSL2.

Control circuit 310 essentially comprises a high voltage switch GDSC, a first voltage branch circuit 310A (illustrated within a dashed line rectangle) and a second voltage branch circuit 310B (illustrated within another dashed line rectangle). Branch circuit 310A serves to speed-up attainment of the ON state of the load switches GDSL1 and GDSL2 such that conduction can occur through one or the other load switch if the potential of the anode and cathode terminals thereof is sufficient to support conduction, or it can inhibit conduction through the load switches by switching and maintaining them in an OFF state. Branch circuit 310B serves to help 310A to switch GDSL1 and GDSL2 to an OFF state and therefore helps interrupt or inhibit conduction between X0 and Y0 independent of the potentials applied thereto so long as these applied potentials are within preselected limits.

Control circuitry 310 comprises a high voltage switch GDSC, which for illustrative purposes is the switch structure GDS2 illustrated in FIG. 1, a first current limiter CL1, which for illustative purposes is the structure illustrated in FIG. 2, n—p—n transistors T1, T6, T7, and T8, p—n—p transistors T2, T3, T4, and T5, n—p—n phototransistors T9 and T10, which each have a photosensitive base region 341, 345, a diode D1, resistors R1, R2, R3, and R4, and a capacitor C1. A first input terminal 312 is coupled to R1, which is in turn coupled to the bases of T2 and T3 and to a terminal 314. The emitter of T2 is coupled to a terminal 316 and to R2, which is also coupled to a terminal 318, the emitter of T3 and the base of T4. The collector of T2 is coupled to the base of T1 and to a terminal 320. The collector and emitter of T1 are coupled to output terminal 322 and terminal X0, respectively. The collector of T3 is coupled to the collector of T6, the gate of GDSC, and to a terminal 322. The emitters of T4 and T5 are coupled together to a terminal 324 which is coupled to a first voltage supply (source) V1. The collector of T4 is coupled to the base of T5, one terminal of CL1, and to a terminal 326. A second terminal of CL1, in a preferred embodiment, is coupled to the cathode of GDSC and terminal 332, but it can instead be coupled to power supply (source) Vref as is indicated by the dashed line. The collector of T5 is coupled to the base of T6 and to a terminal 328. The emitter of T6 is coupled to the anode of GDSC, to the cathode of D1, and to a terminal 330. The cathode of GDSC is coupled to a second terminal of CL1 and to terminal 332. The anode of D1 is coupled to the emitter of T8 and to a terminal 338. The base of T8 is coupled to the emitter of T10 and to a terminal 340. The collectors T8 and T10 are coupled together to the emitter of T7 and to a terminal 342. The base of T7 is coupled to a terminal 344 and to the emitter of T9. The collectors of T7 and T9 are coupled to one terminal of R4 and to a terminal 346. A second terminal of R4 is coupled to a first terminal of R3 and C1 and to a terminal 348. A second terminal of C1 is coupled to a terminal 352 which is coupled to a potential supply (source) Vref. A second terminal of R3 is coupled to a terminal 350 which is coupled to a potential supply (source) V2. The base regions of T9 and T10 are photosensitive. Terminal X0 is coupled through a resistor R5 to a terminal 354 which is coupled to a potential supply (source) V3. Terminal Y0 is coupled through a resistor R6 to a terminal 356 which is coupled to a potential supply (source) V4.

The combination of T7 and T9 form one photo-Darlington pair and the combination of T8 and T10 form a second Darlington pair. These two Darlington pairs are connected together in series. With light incident on the photosensitive base regions 341, 345 to T9 and T10, terminals 346 and 338 are coupled together via a relatively low impedance path. With the light removed, the two terminals are electrically isolated. The series combination of two such photo-Darlington pairs is used to provide a high voltage and high current capability switch. This allows control circuitry 310 to be electrically isolated from V2 by eliminating incident light on the bases of T9 and T10. Other high voltage and high current switches can be substituted for the photo-Darlington pairs.

The basic operation is as follows: Assuming X0 and Y0 are coupled through current limiting resistance (not illustrated) to +220 volts and −220 volts, respectively, conduction occurs through GDSL2 if the potential of gate terminal 332 is at a potential level which is near or below +220 volts. With V1 = +320 volts, V2 = +285 volts, Vref = 0 volts, and V3 = V4 = −48 volts, and current limiter CL1 limiting current therethrough to 1—14 microamperes, control circuitry 310 is capable of controlling the state of GDSL1 and GDSL2 by providing the needed potentials at terminal 332 and a source of current into terminal 332.

Assuming first that it is desired to set GDSL2 to an ON (conducting) state, an input voltage signal having a level of typically +315 volts (a low or "0") is applied to input terminal 312 and light is illuminated onto the photosensitive bases of T9 and T10. The emitter-base junctions of T2, T3, and T4 become forward-biased and the potential of the base of T1 (terminal 320) reaches a sufficiently positive potential with respect to the emitter (terminal X0) to forward-bias the emitter-base junction of T1 and thereby cause T1 to turn ON and pull down the potential of the collector thereof (terminal 332) to a value close to that of the potential of X0. This leaves the gate and anode of GDSL2 at close to the same potential and thus GDSL 2 is in the ON state and conducts current from X0 to Y0. With T3 biased ON and conducting T4 is biased on since the emitter-base junction thereof is forward biased. Thus an electrical path through T4, CL1, T1 and R5 exists between V1 and V3. With T4 biased ON and conducting current through the emitter-collector thereof, the potential appearing at the base of T5 (terminal 326) is insufficient to forward-bias the emitter-base junction of T5 since the collector-emitter potential of T4 is designed to be less than the potential needed to forward-bias the emitter-base junction of T5. Thus, T5 is biased OFF and terminal 328 is electrically isolated from V1. Because the base terminal 328 of T6 is electrically floating, T6 is biased off. Terminals 328 and 330 are now electrically isolated from V1. The gate (terminal 322) of GDSC is at a potential near V2 since T3 is biased on. The anode terminal 330 is at a potential between approximately V1 and V2. While the anode terminal 330 is near V1 in potential, GDSC is ON and conducts until the potential of anode terminal 330 drops to approximately 20 volts below the potential of gate terminal 322. GDSC then switches OFF and conduction therethrough ceases. In addition, terminal 332 is also isolated from V2 since GDSC is OFF.

It is thus clear that one of the functions of branch circuit 310A is rapidly to switch load switch GDSL2 to the ON state and thus allow conduction therethrough.

Assume that it is now desired to switch GDSL2 to the OFF (blocking) state. Input terminal 312 is set to the level of +320 volts (a high level or "1"). This turns off T2, T3, and T4. T5 now becomes biased on and is typically operated in saturation such that terminal 328 rises in potential and forward-biases the emitter-base junction of T6. This brings the voltage of 330 near V1 and thus switches GDSC to the ON state. This causes terminal 332 to rise in potential to a level close to V1. This potential on terminal 332 is sufficient to switch GDSL2 to the OFF (blocking) state if there is a sufficient positive current flow into the gate of GDSL2. Minority carriers (e.g., electrons) emitted at the cathode of GDSL2 and collected at the gate (terminal 332) constitute the equivalent of positive current flow from V1 through T5, the emitter-base junction of T6, GDSC, and into the gate of GDSL2. During turn-off this current flow can be substantial and as a result it is necessary to have a high voltage and current device such as GDSC to switch GDSL2 to the OFF state. A high voltage and high current transistor would be expensive.

T5 is typically designed to have a relatively low current handling capability. As the current flow through T5 begins to increase, the voltage drop across the collector-emitter of T5 increases significantly until the potential of terminal 328 decreases to a level near V2. T5 then essentially limits further conduction therethrough. D1, which had previously been reverse-biased, now becomes forward-biased. With light incident on the photosensitive bases 345 and 341 of T9 and T10, respectively, positive current flows from C1 and V2 into terminal 330 and through GDSC and into the gate of GDSL2. The potential of terminal 330 drops to a level below but close to that of V2. The values of R3, R4, C1, and the potential of V2 are selected to provide substantially more current than can be provided by T5. Accordingly, GDSL2 is switched to the OFF state.

It is thus clear that another function of 310A is to switch off GDSL2 and maintain it in the OFF state, and 310B serves to help 310A switch GDSL2 to the OFF state and to therefore help interrupt or inhibit conduction between X0 and Y0 independent of the potentials applied to X0 and Y0 independent of the potentials applied to X0 and Y0 so long as these applied potentials are within preselected limits.

If GDSL2 fails to switch OFF C1 becomes essentially discharged. Then the light incident on T9 and T10 is removed allowing C1 to recharge and terminal 312 is returned to +315 volts. This resets GDSC to the OFF state and allows GDSL2 to continue to be in the ON state and conducting. Light is again illuminated on the photosensitive bases of T9 and T10 and then the potential of 312 is raised back to +320 volts. GDSC is again switched to the ON state and another attempt is made at causing GDSL2 to be switched from the ON to the OFF state.

In one embodiment R1, R2, R3, R4, R5, and R6 are typically 1000, $10^5$, $10^4$, 500, $10^6$, and $10^6$ ohms, respectively, and C1 is 0.1 microfarads.

The combination of T7, T9, T8, and T10, which act as essentially a single high voltage and high current switch, are relatively expensive components. R3, R4, C1, T7, T9, T8, and T10 can be shared between a number of control circuitries 310.

If Y0 is more positive in potential than X0, then GDSL2 does not conduct and GDSL1 is affected in essentially the same manner as is described above for the operation of GDSL2.

Referring now to FIG. 4, there is illustrated a switching system 400 comprising control circuitry 410 (contained in the large dashed line rectangle), two pairs of bidirectional switches GDSL10, GDSL20, and GDSL3, GDSL4, and resistors R50, R60, R7, and R8.

Control circuitry 410 essentially comprises a first voltage branch 410A (illustrated within another dashed line rectangle) and a second voltage branch circuit 410B (illustrated within still another dashed line rectangle). The components of 410B are essentially the same as the components of 310B of FIG. 3, and they function in essentially the same way. The components of 410A are essentially the same as those of 310A of FIG. 1, except that four additional devices, n—p—n transistor T10A, p—n—p transistor T20A, and diodes D2 and D3 have been added to facilitate the controlling of a second bidirectional switch which comprises gated diode switches GDSL3 and GDSL4. An output terminal 438 of 410B is illustrated connected to the anodes of diodes D4, D5 ... Dn. Each of these diodes represents a branch circuit which is essentially identical to 410A, and which has a separate pair of bidirectional switches, like GDSL10, GDSL20, and GDSL3 and GDSL4 coupled thereto. The control voltage branch 410B of control circuitry 400 is thus shared by n other control circuits which are essentially identical to 400.

D2 and D3 serve to electrically isolate terminals X00 and Y00 from X1 and Y1. T20A serves to control T10A in the same manner that T20 controls T10. Components of 400 which are essentially identical to components of control circuitry 310 of FIG. 3 have the same reference denotation with a "0" added thereto. Corresponding terminals have a "4" as the first reference number whereas in FIG. 3 the first reference number is a "3".

Control circuitry 400 has been built and found to be functional. Four voltage branch circuits 410A and one shared branch circuit 410B were used to control the states of eight pairs of gated diode switches. Each of the pairs of gated diode switches were similar to structure 10 of FIG. 1 except that there was no electrode coupled to region 40. Transistors T10 and T10A, and the corresponding six other transistors (not illustrated), were separate transistors. All of the circuitry of the first voltage branches 410A and the eight pairs of gated diode switches were fabricated on a single integrated circuit chip having an area of 14 square millimeters using dielectric isolation of components. The average turn-on time of a gate diode switch used with circuit 400 is 300 microseconds. The turn-off time is 50 microseconds. The average power dissipation of each of the branch circuits 410A is 5 milliwatts.

The embodiments described herein are intended to be illustrative of the general principles of the present invention. Various modifications are possible consistent with the spirit of the invention. For example, transistor T6 of FIG. 3 and T60 of FIG. 4 can be eliminated. In such cases, the collector of T5 of FIG. 3 is connected directly to the anode of GDSC and the collector of T50 of FIG. 4 is connected directly to the anode of GDSC0. Still further, other high voltage and high current switches, such as a gated diode switch, could be substituted for the photo-Darlington pairs provided appropriate control circuitry is provided to control same. Still further, the junction transistors could be replaced by field effect transistors provided the polarities and magnitudes of the power supplies and circuit configurations are appropriately modified as is well known in the art. Still further, R1, R2, R3, R4, R5 and R6 can be standard integrated circuit resistors or pinch resistors. Still further, the current limiter can be a variety of different types of resistors or a junction field effect transistor. Still further, if at least one of the load GDSs of each pair is like GDS1 of FIG. 1, then the transistor which selectively causes the gate and cathode (anode) to be close to each other in potential, transistor T1 (T10A, T10 ...), is part of the GDS and terminal 320 (420, 420a ...) is connected directly to electrode 50 (or its equivalent) of the load GDS. CL1 and CL10 can be connected to V2 and V20, respectively, instead of being connected to the cathodes of the respective GDSCs. D2 and D3 can be eliminated if a second control gated diode switch, like GDSC0, is added with its anode common to the anode of GDSC and its gate common to the gate of GDSC, and its cathode connected directly to the gates of GDSL3 and GDSL4. In this case the cathode of GDSC0 is connected directly to the gates of GDSL10 and GDSL20. Still further, T5 and T50 can be designed to have relatively high current capabilities. The load switches GDSLs can be switched to the OFF state solely by the first branch circuits 310A and 410A so long as the current flow through the load switches GDSLs is within preselected limits. If this current flow is greater than these limits then the second branch circuits 310B and 410B are necessary to switch the load switches GDSLs to the OFF state.

Matter described herein is also the subject of claims of our copending application no. 81900372.4, published under the International Publication Number WO 81/01925, to which reference is directed.

**Claims**

1. Control circuit for a first switching device (GDSL2) of the type comprising a semiconductor body (16) a bulk portion of which is of a relatively high resistivity, a first region (18) of a first conductivity type and of a relatively low resistivity, a second region (24) of a second conductivity type opposite that of the first conductivity type, the first and second regions being connected to output terminals (X0, Y0) of the switching device, a gate region (20) of the second conductivity type, and a control terminal (G) coupled to the gate region, the first, second and gate regions being mutually separated by portions of the semiconductor body bulk portion, and the parameters of the device being such that, with a first voltage applied to the control terminal a potential is established within a cross-sectional portion of the bulk of the semiconductor body which is substantially different from that of the potential of the first and second regions and which prevents current flow between the first and second regions, and, with a second voltage applied to the control terminal and with appropriate voltages applied to the output terminals, a relatively low resistance current path is established between the first and second regions by dual carrier injection, characterized by a second switching device (GDSC) of the same type as the first switching device and having a first output terminal (332) being coupled to the control terminal of the first switching device (GDSL2), a first branch circuit (310A) coupled to the second switching device (GDSC) for controlling conduction between the first (18) and second (24) regions thereof and adapted to couple a first potential source (V1) to a second terminal (330) of the second switching device, a second branch circuit (310B) coupled to the second switching device and adapted to be coupled to a second potential source (V2) which is adapted to supply additional current into the second output terminal (330) of the second switching device if that second output terminal (330) assumes a potential level which is significantly below a preselected potential level.

2. Circuit as claimed in claim 1 wherein the first branch circuit (310A) comprises a third switching device (T5) having output circuitry (328) coupled to the second output terminal (330) of the second switching device and having a control terminal (326) coupled to an input terminal (312) of the circuitry, the third switching device being adapted to selectively electrically isolate the second output terminal (330) of the second switching device (GDSC) from the first potential source (V1), and the second branch circuit (310B) comprises a fourth switching device (T7, T8, T9, T10) having output circuitry (338) coupled to the second output terminal (330) of the second switching device and having a control portion (341, 345), the fourth switching device being adapted to selectively electrically isolate the second output terminal of the second switching device from the second potential source (V2).

3. Circuit as claimed in claim 2 wherein the first branch circuit (310A) includes circuit means (T1) coupled to the control terminal (332) and one of the output terminals (X0) of the first switching device (GDSL2) and having a control terminal (320) coupled to the circuitry input terminal (312) and being adapted to selectively cause the control terminal of the first switching device to be close in potential to the output terminal (X0) of the first switching device (GDSL2) which is coupled to the circuit means (T1).

4. Circuit as claimed in claim 3 including a first resistor (CL1) which is coupled to the control terminal (326) of the third switching device (T5).

5. Circuit as claimed in claim 4 wherein the resistor is a current limiter (CL1) and is coupled to the first output terminal (332) of the second switching device (GDSC).

6. Circuit as claimed in claim 4 or 5 including a fifth switching device (T3) which has output circuitry (318) adapted to be coupled to the first potential source (V1) and to the control terminal (322) of the second switching device (GDSC), and a control terminal (314) coupled to the input terminal (312) of the circuitry.

7. Circuit as claimed in claim 6 wherein the first branch circuit (310A) comprises a diode (D1) whose cathode is coupled to the second output terminal (330) of the second switching device (GDSC) and whose anode is coupled to an output terminal (338) of the fourth switching device (T7, T8, T9, T10), and there is provided sixth (T2), seventh (T4), and eighth (T6) switching devices each having a control terminal and output circuitry, the control terminal (314) of the sixth switching device (T2) being coupled to the circuitry input terminal (312) and the output circuitry being coupled to the output circuitry (318) of the fifth switching device (T3), the control terminal of the seventh switching device (T4), and the control terminal (320) of the circuit means (T1), and there is further provided a capacitor (C1), and second (R1), third (R2), fourth (R3), and fifth (R4) resistors, the second resistor (R1) being coupled to the circuitry input terminal (312) and to the control terminal (314) of the sixth switching device (T2), the third resistor (R2) being coupled to the output circuitry (316) of the sixth switching device (T2) and to the output circuitry (318) of the fifth switching device (T3), the fifth resistor (R4) being coupled to an output terminal (346) of the fourth switching device (T7, T8, T9, T10), to a first terminal (348) of the capacitor (C1) and to the fourth resistor (R3), and the fourth resistor (R3) being adapted to be coupled to the second potential source (V2).

8. Circuit as claimed in claim 7 wherein the third (T5), fifth (T3), sixth (T2) and seventh (T4) switching devices are p—n—p transistors, the circuit means (T1) is an n—p—n transistor, and the fourth switching device (T7, T8, T9, T10) comprises a first Darlington pair of transistors (T7 and T9), and a second Darlington pair of transistors (T8 and T10), with two of the transistors having photosensitive base regions (345, 341).

9. Circuit as claimed in claim 8 including sixth (R5) and seventh (R6) resistors, the sixth (R5) resistor being coupled to one of the output terminals (X0) of the first switching device (GDSL2) and the seventh (R6) resistor being coupled to the other output terminal (Y0), and an eighth switching device (T6) which is an n—p—n transistor having its collector (322) coupled to the output circuitry of the fifth switching device (T3), its base coupled to the output circuitry (328) of the third switching device (T5), and its emitter coupled to the second output terminal (330) of the second switching device (GDSC).

10. Circuit as claimed in claim 3 wherein the circuit means (T1) is an integral part of the first switching device (GDSL2), and the first switching device (GDSL2) has a shield (base) region (22, 40, 46) which surrounds the second region (24), said shield (base) region (22, 40, 46) being of the first conductivity type and having a separate control terminal (50) connected thereto.

11. Circuit as claimed in any preceding claim wherein the first (GDSL2) and second (GDSC) switching devices are gated diode switches.

**Revendications**

1. Circuit de commande pour un premier dispositif de commutation (GDSL2) du type comprenant une zone de semi-conducteur (16) dont le volume principal présente une résistivité relativement élevée, une première région (18) d'un premier type de conductivité et de résistivité relativement faible, et une seconde région (24) d'un second type de conductivité opposé au premier type de conductivité, les première et seconde régions étant connectées à des bornes de sortie (X0, Y0) du dispositif de commutation, une région de grille (20) du second type de conductivité, et une borne de commande (G) connectée à la région de grille, les première et seconde régions et la région de grille étant mutuellement séparées par des parties du volume principal de la zone de semiconducteur, et les paramètres du dispositif étant tels que, avec une première tension appliquée à la borne de commande, il existe dans une partie de la section du volume principal de la zone de semiconducteur un potentiel notablement différent du potentiel des première et seconde régions, ce qui empêche la circulation d'un courant entre les première et seconde régions, et avec une seconde tension appliquée à la borne de commande et avec des tensions appropriées appliquées aux bornes de sortie, un chemin de courant à résistance relativement faible est établi entre les première et seconde régions par double injection de porteurs, caractérisé par un second dispositif de commutation (GDSC) du même type que le premier dispositif de commutation et ayant une première borne de sortie (332) connectée à la borne de commande du premier dispositif de commutation (GDSL2), un premier circuit de dérivation (310A) connecté au second dispositif de commutation (GDSC) pour commander la conduction entre les première (18) et seconde (24) régions de ce dernier, et prévu de façon à connecter une première source de potentiel (V1) à une seconde borne (330) du second dispositif de commutation, un second circuit de dérivation (310B) connecté au second dispositif de commutation et prévu de façon à être connecté à une seconde source de potentiel (V2) qui est destinée à fournir un courant supplémentaire à la seconde borne de sortie (330) du second dispositif de commutation, si cette seconde borne de sortie (330) prend un niveau de potentiel qui est notablement inférieur à un niveau de potentiel présélectionné.

2. Circuit selon la revendication 1, dans lequel le premier circuit de dérivation (310A) comprend un troisième dispositif de commutation (T5) ayant un circuit de sortie (328) connecté à la seconde borne de sortie (330) du second dispositif de commutation, et ayant une borne de commande (326) connectée à une borne d'entrée (312) du circuit, le troisième dispositif de commutation étant conçu de façon à isoler électriquement de façon sélective la seconde borne de sortie (330) du second dispositif de commutation (GDSC) par rapport à la première source de potentiel (V1), et le second circuit de dérivation (310B) comprend un quatrième dispositif de commutation (T7, T8, T9, T10) ayant un circuit de sortie (338) connecté à la seconde borne de sortie (330) du second dispositif de commutation, et ayant une partie de commande (341, 345), le quatrième dispositif de commutation étant conçu de façon à isoler électriquement de façon sélective la seconde borne de sortie du second dispositif de commutation par rapport à la seconde source de potentiel (V2).

3. Circuit selon la revendication 2, dans lequel le premier circuit de dérivation (310A) comprend un élément de circuit T1) connecté à la borne de commande (332) et à l'une des bornes de sortie (X0) du premier dispositif de commutation (GDSL2), et ayant une borne de commande (321) connectée à la borne d'entrée du circuit (312), et conçu de façon à agir sélectivement pour donner à la borne de commande du premier dispositif de commutation un potentiel proche de celui de la borne de sortie (X0) du premier dispositif de commutation (GDSL2) qui est connectée à l'élément de circuit (T1).

4. Circuit selon la revendication 3, comprenant une première résistance (CL1) qui est connectée à la borne de commande (326) du troisième dispositif de commutation (T5).

5. Circuit selon la revendication 4, dans lequel la résistance est un limiteur de courant (CL1) et est connectée à la première borne de sortie (332) du second dispositif de commutation (GDSC).

6. Circuit selon la revendication 4 ou 5, comprenant un cinquième dispositif de commutation (T3) qui comporte un circuit de sortie (318) prévu pour être connecté à la première source de potentiel (V1) et à la borne de commande (322) du second dispositif de commutation (GDSC), et une borne de commande (314) qui est connectée à la borne d'entrée (312) du circuit.

7. Circuit selon la revendication 6, dans lequel le premier circuit de dérivation (310A) comprend une diode (D1) dont la cathode est connectée à la seconde borne de sortie (330) du second dispositif de commutation (GDSC) et dont l'anode est connectée à une borne de sortie (338) du quatrième dispositif de commutation (T7, T8, T9, T10), et il existe des sixième (T2), septième (T4) et huitième (T6) dispositifs de commutation, ayant chacun une borne de commande et un circuit de sortie, et la borne de commande (314) du sixième dispositif de commutation (T2) est connectée à la borne d'entrée du circuit (312) et le circuit de sortie est connecté au circuit de sortie (318) du cinquième dispositif de commutation (T3), à la borne de commande du septième dispositif de commutation (T4) et à la borne de commande (321) de l'élément de circuit (T1), et il existe en outre un condensateur (C1), et des seconde (R1), troisième (R2), quatrième (R3) et cinquième (R4) résistances, et la seconde résistance (R1) est connectée à la borne d'entrée du circuit (312) et à la borne de commande (314) du sixième dispositif de commutation (T2), la troisième résistance (R2) est connectée au circuit de sortie (316) du sixième dispositif de commutation (T2) et au circuit de sortie (318) du cinquième dispositif de commutation (T3), la cinquième résistance (R4) est connectée à une borne de sortie (346) du quatrième dispositif de commutation (T7, T8, T9, T10), à une première borne (348) du condensateur (C1) et à la quatrième résistance (R3), et la quatrième résistance (R3) est prévue de façon à être connectée à la seconde source de potentiel (V2).

8. Circuit selon la revendication 7, dans lequel les troisième (T5), cinquième (T3), sixième (T2) et septième (T4) dispositifs de commutation sont des transistors p—n—p, l'élément de circuit (T1) est un transistor n—p—n, et le quatrième dispositif de commutation (T7, T8, T9, T10) comprend une première paire Darlington de transistors (T7 et T9) et une seconde paire Darlington de transistors (T8 et T10), et deux des transistors ont des régions de base photosensibles (345, 341).

9. Circuit selon la revendication 8, comprenant des sixième (R5) et septième (R6) résistances, et la sixième résistance (R5) est connectée à l'une des bornes de sortie (X0) du premier dispositif de commutation (GDSL2) tandis que la septième résistance (R6) est connectée à l'autre borne de sortie (Y0), et un huitième dispositif de commutation (T6) qui est un transistor n—p—n dont le collecteur (322) est connecté au circuit de sortie du cinquième dispositif de commutation (T3), dont la base est connectée au circuit de sortie (328) du troisième dispositif de commutation (T5), et dont l'émetteur est connecté à la seconde borne de sortie (330) du second dispositif de commutation (GDSC).

10. Circuit selon la revendication 3, dans lequel l'élément de circuit (T1) fait partie intégrante du premier dispositif de commutation (GDSL2), et le premier dispositif de commutation (GDSL2) comporte une région d'écran (base) (22, 40, 46) qui entoure la seconde région (24), cette région d'écran (base) (22, 40, 46) ayant le premier type de conductivité et étant connectée à une borne de commande séparée (50).

11. Circuit selon l'une quelconque des revendications précédentes, dans lequel les premier (GDSL2) et second (GDSC) dispositifs de commutation sont des éléments de commutation à diode commandée.

**Patentansprüche**

1. Steuerschaltung für ein erstes Schaltbauteil (GDSL2), das einen Halbleiterkörper (16) aufweist mit einem Hauptteil verhältnismäßig hohen spezifischen Widerstandes, mit einer ersten Zone (18) eines ersten Leitfähigkeitstyps und verhältnismäßig niedrigen spezifischen Widerstandes, mit einer zweiten Zone (24) eines zweiten Leitfähigkeitstyps, der dem ersten Leitfähigkeitstyp entgegengesetzt ist, wobei die erste und die zweite Zone mit Ausgangsanschlüssen (X0, Y0) des Schaltbauteils verbunden sind, mit einer Gatezone (20) des zweiten Leitfähigkeitstyps und mit einem mit der Gatezone verbundenen Steueranschluß (G), wobei die erste, die zweite und die Gatezone voneinander durch Bereiche des Halbleiterkörper-Hauptteils getrennt und die Parameter des Bauteils so gewählt sind, daß bei Anliegen einer ersten Spannung am Steueranschluß in einem Querschnittsbereich des Hauptteils ein Potential erzeugt wird, das wesentlich verschieden von dem der ersten und zweiten Zone ist und einen Stromfluß zwischen der ersten und der zweiten Zone verhindert, und daß bei Anliegen einer zweiten Spannung am Steueranschluß und geeigneter Spannungen an den Ausgangsanschlüssen ein Stromweg mit verhältnismäßig niedrigem Widerstand zwischen der ersten und der zweiten Zone durch doppelte Trägerinjektion erzeugt wird, gekennzeichnet durch ein zweites Schaltbauteil (GDSC) des gleichen Typs wie das erste Schaltbauteil mit einem ersten Ausgangsanschluß (332), der mit dem Steueranschluß des ersten Schaltbauteils (GDSL2) verbunden ist, eine erste Zweigschaltung (310A), die mit dem zweiten Schaltbauteil (GDSC) verbunden ist, um die Stromleitung zwischen dessen erster (18) und zweiter (24) Zone zu steuern und in der Lage ist, eine erste Potentialquelle (V1) an einen zweiten Anschluß (330) des zweiten Schaltbauteils anzuschalten, und eine zweite Zweigschaltung (310B), die mit dem zweiten Schaltbauteil verbunden und an eine zweite Potentialquelle (V2) anschaltbar ist, welche in der Lage ist, zusätzlichen Strom in den zweiten Ausgangsanschluß (330) des zweiten Schaltbauteils zu liefern, wenn dieser zweite Ausgangsanschluß (330) einen deutlich unter einem vorgegebenen Potentialpegel liegenden Potentialpegel annimmt.

2. Steuerschaltung nach Anspruch 1, bei der die erste Zweigschaltung (310A) ein drittes Schaltbauteil (T5) mit einer Ausgangsschaltung (328), die mit dem zweiten Ausgangsanschluß (330) des zweiten Schaltbauteils verbunden ist, und mit einem Steueranschluß (326) aufweist, der mit einem Eingangsanschluß (312) der Steuerschaltung verbunden ist, wobei das dritte Schaltbauteil in der Lage ist, den zweiten Ausgangsanschluß (330) des zweiten Schaltbauteils (GDSC) selektiv von der ersten Potentialquelle (V1) elektrisch zu isolieren, und bei der die zweite Zweigschaltung (310B) ein viertes Schaltbauteil (T7, T8, T9, T10) mit einer Ausgangsschaltung (338), die mit dem zweiten Ausgangsanschluß (330) des zweiten Schaltbauteils verbunden ist und mit einem Steuerteil (341, 345) aufweist, wobei das vierte Schaltbauteil in der Lage ist, selektiv den zweiten Ausgangsanschluß des zweiten Schaltbauteils von der zweiten Potentialquelle (V2) elektrisch zu isolieren.

3. Steuerschaltung nach Anspruch 2, bei der die erste Zweigschaltung (310A) Schaltmittel (T1) enthält, die mit dem zweiten Steueranschluß (332) und einem der Ausgangsanschlüsse (X0) des ersten Schaltbauteils (GDSL2) verbunden sind, einen mit dem Eingangsanschluß (312) der Steuerschaltung verbundenen Steueranschluß (320) besitzen und in der Lage sind, selektiv zu veranlassen, daß der Steueranschluß des ersten Schaltbauteils ein Potential annimmt, das dicht bei dem Potential des mit den Schaltmitteln (T1) verbundenen Ausgangsanschluß (X0) des ersten Schaltbauteils (GDSL2) liegt.

4. Steuerschaltung nach Anspruch 3 mit einem ersten Widerstand (CL1)), der mit dem Steueranschluß (326) des dritten Schaltbauteils (T5) verbunden ist.

5. Steuerschaltung nach Anspruch 4, bei der der Widerstand ein Strombegrenzer (CL1) ist und mit dem ersten Ausgangsanschluß (332) des zweiten Schaltbauteils (GDSC) verbunden ist.

6. Steuerschaltung nach Anspruch 4 oder 5 mit einem fünften Schaltbauteil (T3), das eine an die erste Potentialquelle (V1) und den Steueranschluß (322) des zweiten Schaltbauteils (GDSC) anschaltbare Ausgangsschaltung (318) und einen Steueranschluß (314) aufweist, der mit dem Eingangsanschluß (312) der Steuerschaltung verbunden ist.

7. Steuerschaltung nach Anspruch 6, bei der die erste Zweigschaltung (310A) eine Diode (D1) aufweist, deren Kathode mit dem zweiten Ausgangsanschluß (330) des zweiten Schaltbauteils (GDSC) und deren Anode mit einem Ausgangsanschluß (338) des vierten Schaltbauteils (T7, T8, T9, T10) verbunden sind, bei der ein sechstes (T2), siebtes (T4) und achtes (T6) Schaltbauteil vorgesehen ist, die je einen Steueranschluß und eine Ausgangsschaltung besitzen, wobei der Steueranschluß (314) des sechsten Schaltbauteils (T2) mit dem Eingangsanschluß (312) der Steuerschaltung und die Ausgangsschaltung mit der Ausgangsschaltung (318) des fünften Schaltbauteils (T3), dem Steueranschluß des siebten Schaltbauteils (T4) und dem Steueranschluß (320) der Schaltmittel (T1) verbunden sind, und bei der ferner ein Kondensator (C1) sowie ein zweiter (R1), dritter (R2), vierter (R3) und fünfter (R4) Widerstand vorgesehen sind, wobei der zweiten Widerstand (R1) mit dem Eingangsanschluß (312) der Steuerschaltung und dem Steueranschluß (314) des sechsten Schaltbauteils (T2) verbunden ist, der dritte Widerstand (R2) mit der Ausgangsschaltung (316) des sechsten Schaltbauteils (T2) und der Ausgangsschaltung (318) des fünften Schaltbauteils (T3) verbunden ist, der fünfte Widerstand (R4) mit einem Ausgangsanschluß (346) des vierten Schaltbauteils (T7, T8, T9, T10), einem ersten Anschluß (348) des Kondensators (C1) und dem vierten Widerstand (R3) verbunden ist, und der vierte Widerstand (R3) an die zweite Potentialquelle (V2) anschaltbar ist.

8. Steuerschaltung nach Anspruch 7, bei der das dritte (T5), fünfte (T3), sechste (T2) und siebte (T4) Schaltbauteil pnp-Transistoren sind, die Schaltmittel (T1) ein npn-Transistor sind und das vierte Schaltbauteil (T7, T8, T9, T10) ein erstes Darlington-Transistorpaar (T7 und T9) und ein zweites Darlington-Transistorpaar (T8 und T10) aufweist, wobei zwei dieser Transistoren eine fotoempfindliche Basiszone (345, 341) besitzen.

9. Steuerschaltung nach Anspruch 8 mit einem sechsten (R5) und siebten (R6) Widerstand, wobei der sechste Widerstand (R5) mit einem der Ausgangsanschlüsse (X0) des ersten Schaltbauteils (GDSL2) und der siebte Widerstand (R6) mit dem anderen Ausgangsanschluß (Y0) verbunden ist, und mit einem achten Schaltbauteil (T6) in Form eines npn-Transistors, dessen Kollektor (322) mit der Ausgangsschaltung des fünften Schaltbauteils (T3), dessen Basis mit der Ausgangsschaltung (328) des dritten Schaltbauteils (T5) und dessen Emitter mit dem zweiten Ausgangsanschluß (330) des zweiten Schaltbauteils (GDSC) verbunden ist.

10. Steuerschaltung nach Anspruch 3, bei der die Schaltmittel (T1) integraler Bestandteil des ersten Schaltbauteils (GDSL2) sind und bei der das erste Schaltbauteil (GDSL2) eine Abschirm-(Basis)-Zone (22, 40, 46) besitzt, die die zweite Zone (24) umgibt, wobei die Abschirm-(Basis)-Zone (22, 40, 46) von ersten Leitfähigkeitstype ist und einen mit ihr verbundenen, getrennten Steueranschluß (50) aufweist.

11. Steuerschaltung nach einem der vorhergehenden Ansprüche, bei der das erste (GDSL2) und zweite (GDSC) Schaltbauteil gesteuerte Diodenschalter sind.

FIG. 1

FIG. 2

FIG. 3

1

FIG. 4

0 053 113